# EUROPÄISCHE PATENTSCHRIFT

(11) **EP 0 764 978 B1**
(45) Veröffentlichungstag und Bekanntmachung des Hinweises auf die Patenterteilung: **24.10.2007**
(21) Anmeldenummer: 96112831.1
(22) Anmeldetag: 08.08.1996
(51) Int. Cl.: H01L 21/60

(54) **Verfahren zur Befestigung elektronischer Bauelemente auf einem Substrat durch Drucksintern**
Method for bonding electronic components on a substrate by means of pressure sintering
Procédé pour la fixation de composants électroniques au-dessus d'un substrat au moyen de frittage par pression

(30) Priorität: 11.09.1995 DE 19533561
(43) Veröffentlichungstag der Anmeldung: 26.03.1997
(73) Patentinhaber: Infineon Technologies AG, 81669 München (DE)
(72) Erfinder: Schwarzbauer, Herbert, Dr., 81373 München (DE)
(74) Vertreter: Patentanwälte Westphal, Mussgnug & Partner

(56) Entgegenhaltungen:
- EP-A- 0 242 626
- US-A- 4 856 185
- EIFERT H ET AL: "PREPARATION AND DC-PROPERTIES OF NANOPOROUS METAL NETWORKS" INTERNATIONAL JOURNAL OF ELECTRONICS, Bd. 73, Nr. 5, November 1992, Seiten 945-947, XP000605084

## Beschreibung

Die Erfindung betrifft ein Verfahren zur Befestigung elektronischer Bauelemente auf einem Substrat durch Drucksintern nach dem Patentanspruch 1.

Ein Verfahren ist beispielsweise aus der EP-0 242 626 B1 (GR 86 P 1442 E) bekannt. Bei diesem bekannten Verfahren wird zur Erzeugung der Schicht aus dem Metallpulver eine aus dem Metallpulver und einem Lösungsmittel bestehende Paste schichtförmig auf die zu beschichtende Kontaktfläche aufgetragen und dann die aufgetragene Paste getrocknet. Vor dem Zusammenbringen von Bauelement und Substrat wird die aufgebrachte Schicht zur besseren Handhabung der beschichteten Komponente zweckmäßigerweise vorgesintert beispielsweise bei einer Temperatur von 250°C.

Die Schicht aus dem Metallpulver dient als Ausgleichsschicht für Oberflächenrauhigkeiten und muß verdichtbar und porös sein.

Die im Anspruch 1 angegebene Erfindung hat den Vorteil, daß die Herstellung der Schicht aus dem sinterfähigen Metallpulver das gleichmäßige Aufbringen auf die betreffende Kontaktfläche und das Vorsintern zur besseren Handhabung der mit dieser Schicht beschichteten Komponente in einem Arbeitsgang stattfinden.

Bevorzugte und vorteilhafte Ausgestaltungen des erfindungsgemäßen Verfahrens gehen aus den Ansprüchen 2 bis 6 hervor.

Es sei darauf hingewiesen, daß die Erzeugung einer Schicht auf einer Fläche durch Abscheiden und Aufwachsen eines durch Verdampfen und Kondensieren eines Metalls bei geringem Druck gewonnenen nanokristallinen Metallpulvers auf der Fläche bereits aus INT.J.Electronics, 1992, Vol. 73, Nr. 5, Seiten 945 bis 947 und aus Journal of Appl. Physics, Vol. 47, Nr. 5, Mai 1976 Seiten 2200 bis 2219 bekannt ist. Die Erfindung beruht demgegenüber auf der neuen Erkenntnis, daß das aus diesen Dokumenten für sich bekannte Verfahren zum Abscheiden eines Metallpulvers hervorragend zur Erzeugung der für ein Verfahren zur Befestigung elektronischer Bauelemente auf einem Substrat durch Drucksintern erforderlichen Schicht aus einem Metallpulver geeignet ist.

Die Erfindung wird in der nachfolgenden Beschreibung anhand der Figuren beispielhaft näher erläutert. Es zeigen
- Figur 1: im Querschnitt ein Substrat,
- Figur 2: im Querschnitt einen großflächigen Leistungshalbleiter,
- Figur 3: in schematischer Darstellung und im Querschnitt eine Abscheidekammer zur Erzeugung der Schicht aus dem nano-kristallinen Metallpulver auf der Kontaktfläche des Substrats gemäß Figur 1,
- Figur 4: das fertig beschichtete Substrat nach Figur 1 und
- Figur 5: das mit dem beschichteten Substrat nach Figur 4 zusammengebrachte Bauteil nach Figur 2.

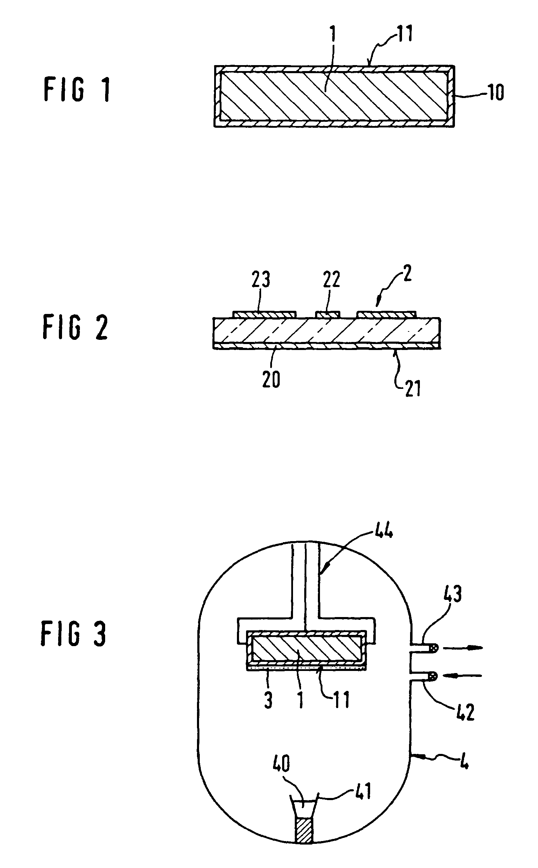

Das in Figur 1 dargestellte Substrat 1 besteht z. B. aus einer 1,5 mm starken Scheibe aus beispielsweise Molybdän mit einem Durchmesser von etwa 30 mm, die allseitig mit einer Kontaktschicht 10 aus beispielsweise Silber und einer Stärke von etwa 2 bis 3 µm beschichtet ist. Die Oberfläche 11 der auf einer Flachseite des Substrats 1 befindlichen Schicht 10 bildet die Kontaktfläche des Substrats 1.

Das in Figur 2 dargestellte Bauelement ist beispielsweise ein großflächiger Thyristor, auf einer dessen beiden Flachseiten als Aluminiumstruktur ein Zündkontakt 22 und eine den Zündkontakt 22 kreisförmig umgebende Kathode 23 angeordnet sind. Auf der von dieser einen Flachseite abgekehrten anderen Flachseite des beispielsweise aus Silizium bestehenden Bauelements 2 ist eine Beschichtung 20 aufgebracht, die im einzelnen beispielsweise aus einer 1 µm starken Aluminiumschicht, einer etwa 100 nm starken Titanschicht, einer beispielsweise 100 nm starken Schicht aus Pt und einer etwa 100 nm starken Schicht aus Au besteht. Diese Au-Schicht bildet die Außenseite der Beschichtung 20 und die Oberfläche dieser Au-Schicht bildet die Kontaktschicht 21 des Bauelements 2.

Zur erfindungsgemäßen Beschichtung mit einer Schicht aus sinterfähigem Metallpulver wird die betreffende Komponente, d.h. entweder das Substrat 1 oder das Bauteil 2 oder beide in eine in Figur 3 schematisch dargestellte Abscheidekammer 4 gebracht und in dieser Kammer 4 an einer Halterung 44, deren Temperatur regelbar ist, derart gehaltert, daß die Kontaktfläche 11 und/oder 21 der betreffenden Komponente einem in der Abscheidekammer 4 angeordneten Tiegel 41 zur Aufnahme des zur Beschichtung verwendeten Metalls 40 zugekehrt ist. Bei dem Beispiel nach Figur 3 ist der Einfachheit halber nur eine Komponente, das Substrat 1, in der Abscheidekammer 4 angeordnet. Als Abscheidekammer 4 kann die Anordnung verwendet werden, die aus der Figur 2 und der dazugehörigen Beschreibung im Abschnitt B des obengenannten Dokuments Journal of Appl. Physics hervorgeht.

Die Schicht aus dem sinterfähigen Metallpulver wird dadurch erzeugt, daß das im Tiegel 41 befindliche Metall 40 bei einem geringen Vorvakuumdruck von 100 Pa bis 1000 Pa verdampft und kondensiert wird, wobei ein besonders feinkristallines und sinterfähiges, sog. nanokristallines Metallpulver als feiner Staub gewonnen wird, der sich auf der Kontaktfläche 11 in einer dünnen Schicht 3 abscheidet. Es sei in diesem Zusammenhang insbesondere auf das obengenannte Dokument Journal of Applied Physics, dort insbesondere Abschnitt B auf Seite 205 und 206 verwiesen. Unter nanokristallinem Metallpulver ist hier ein Metallpulver einer Partikelgröße von 1nm bis 500 nm, insbesondere bis 200 nm, vorzugsweise von 1 nm bis 20 nm zu verstehen.

Das Verdampfen und Kondensieren des Metalls 40 und Abscheiden und Aufwachsen des verdampften und kondensierten Metalls als Schicht 3 auf der betreffenden Kontaktschicht 11 und/oder 21 wird vorzugsweise in einer Inertgasatmosphäre vorgenommen, wobei das Inertgas durch einen Einlaß 42 der Abscheidekammer 4 in das Innere der Kammer 4 eingebracht und nach dem Einbringen durch einen Auslaß 43 evakuiert und auf den Vorvakuumdruck gebracht wird.

Insbesondere bei dem beispielhaften Substrat 1 nach Figur 1 und dem beispielhaften Bauteil 2 nach Figur 2 besteht das Metall 40 vorzugsweise aus Silber, das bei einem Druck aus dem Druckbereich von 100 Pa bis 1000 Pa in einer He-Atmosphäre abgeschieden und aufgewachsen wird.

Die Schicht 3 kann vorteilhafterweise bereits während des Aufwachsens, vorzugsweise aber nach dem Aufwachsen dieser Schicht 3 in der Kammer 4 durch leichtes Erwärmen der Halterung 44 auf eine Temperatur aus dem Temperaturbereich von 120 °C bis 350 °C an- oder vorgesintert werden, so daß die betreffenden Komponenten nach Abschluß der Beschichtung mit der Schicht 3 und Herausnahme aus der Abscheidekammer 4 vorteilhafterweise sofort verwendungsfähig sind.

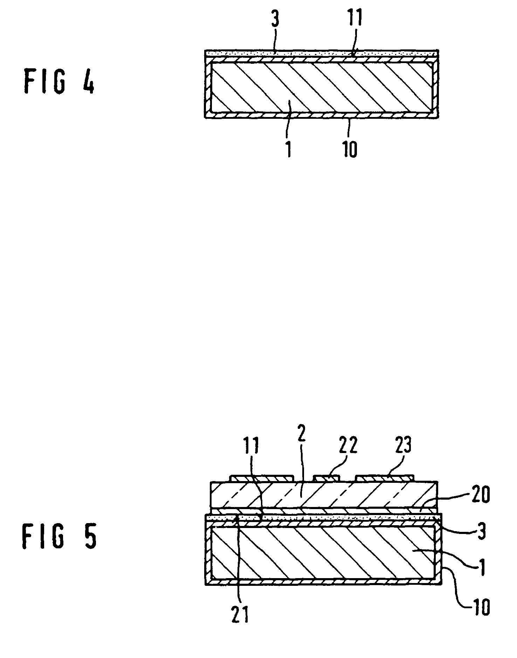

Die Figur 4 zeigt eine solche fertige Komponente in Form des mit der vorgesinterten Schicht 3 beschichteten Substrats 1 nach Figur1.

Das auf diese Weise beschichtete Substrat 1 nach Figur 4 und das Bauteil 2 nach Figur 2 werden in bekannter Weise so zusammengebracht, daß, wie in Figur 5 gezeigt, die Kontaktfläche 21 des Bauteils 2 der Schicht 3 des Substrats 1 zugekehrt ist und diese Schicht 3 ganzflächig kontaktiert, wonach beide Komponenten 1 und 2 mit einem bestimmten Druck zusammengedrückt und in diesem zusammengedrückten Zustand auf eine Sintertemperatur erwärmt, bei der die Schicht 3 gesintert wird.

## Patentansprüche

1. Verfahren zur Befestigung elektronischer Bauelemente, insbesondere großflächiger Leistungshalbleiter, auf einem Substrat durch Drucksintern, bei welchem auf einer Kontaktfläche (21) des Bauelements (2) und/oder einer Kontaktfläche (11) des Substrats (1) mit einer Schicht (3) aus einem sinterfähigen Metallpulver beschichtet wird und nach der Beschichtung Bauelement (2) und Substrat (1) mit ihren einander zugekehrten Kontaktlächen (21, 11) zusammengebracht, mit einem bestimmten Druck zusammengedrückt und in diesem zusammengedrückten Zustand auf eine Sintertemperatur, bei der die Schicht (3) gesintert wird, erwärmt werden,
wobei,
die Schicht (3) durch Abscheiden eines durch Verdampfen und Kondensieren eines Metalls bei einem Gasdruck im Bereich von 100 bis 1000 Pa gewonnenen nanokristallinen Metallpulvers auf der Kontaktfläche (11 und/oder 21) erzeugt wird.

2. Verfahren nach einem der vorhergehenden Ansprüche, **dadurch gekennzeichnet,**
**daß** das Abscheiden der Schicht (3) aus dem nanokristallinen Metallpulver auf der zu beschichtenden Kontaktfläche (11 und/oder 21) in einer Abscheidekammer (4) vorgenommen wird.

3. Verfahren nach Anspruch 2,
**dadurch gekennzeichnet,**
**daß** die auf der zu beschichtenden Kontaktfläche (11 und/oder 21) entstehende Schicht (3) aus dem nanokristallinen Metallpulver in der Abscheidekammer durch Erwärmen auf eine Temperatur im Bereich von 120 °C bis 350 °C vorgesintert wird.

4. Verfahren nach Anspruch 3,
**dadurch gekennzeichnet,**
**daß** das Abscheiden und Aufwachsen der Schicht (3) in einer Inertgasatmosphäre vorgenommen wird.

5. Verfahren nach einem der vorhergehenden Ansprüche,
**dadurch gekennzeichnet,**
**daß** eine Schicht (3) aus Silber bei einem Druck aus dem Druckbereich von 100 bis 1000 Pa in einer He-Atmosphäre abgeschieden und aufgewachsen wird.

## Claims

1. Method for mounting electronic components, in particular large-area power semiconductors, on a substrate by means of pressure sintering, in which a layer (3) composed of a metal powder which can be sintered is coated onto a contact surface (21) of the component (2) and/or onto a contact surface (11) of the substrate (1) and, after the coating process, the mutually facing contact surfaces (21, 11) of the component (2) and substrate (1) are compressed with a specific pressure and are heated in this compressed state to a sintering temperature, at which the layer (3) is sintered,
with
the layer (3) being produced by deposition of a nanocrystalline metal powder, which is obtained by vapour deposition and condensation of a metal at a gas pressure in the range from 100 to 1000 Pa, on the contact surface (11 and/or 21).

2. Method according to one of the preceding claims, **characterized**
**in that** the layer (3) composed of the nanocrystalline metal powder is deposited on the contact surface (11 and/or 21) to be coated in a deposition chamber (4).

3. Method according to Claim 2,
**characterized**
**in that** the layer (3) which is created on the contact surface (11 and/or 21) to be coated and is composed of the nanocrystalline metal powder is pre-sintered in the deposition chamber by heating to a temperature in the range from 120°C to 350°C.

4. Method according to Claim 3,
**characterized**
**in that** the deposition and growth of the layer (3) are carried out in an inert gas atmosphere.

5. Method according to one of the preceding claims,
**characterized**
**in that** a layer (3) composed of silver is deposited and grown in a helium atmosphere at a pressure in the pressure range from 100 to 1000 Pa.

## Revendications

1. Procédé de fixation de composants électroniques, notamment de composants semi-conducteurs de grande surface sur un substrat par frittage sous pression, selon lequel on applique sur une surface de contact (21) du composant (2) et/ou une surface de contact (11) du substrat (1), une couche (3) de poudre métallique susceptible de fritter, et après avoir revêtu le composant (2) et le substrat (1), on les réunit par leur surface de contact (21, 11) en regard, en les comprimant sous une certaine pression et en les chauffant dans cet état comprimé, à une température de frittage à laquelle la couche (3) fritte,
la couche (3) étant réalisée par dépôt d'un métal par vaporisation et condensation sous une pression de gaz de l'ordre de 100-1000 Pa donnant une poudre métallique nanocristalline sur la surface de contact (11 et/ou 21).

2. Procédé selon la revendication 1,
**caractérisé en ce que**
le dépôt de la couche (3) d'une poudre de métal à l'état nanocristallin se fait sur la surface de contact (11 et/ ou 21) à revêtir, dans une chambre de dépôt (4).

3. Procédé selon la revendication 2,
**caractérisé en ce que**
la couche (3) formée sur la surface de contact (11 et/ ou 21) à revêtir est formée de poudre de métal à l'état nanocristallin dans la chambre de dépôt, en étant pré-frittée par chauffage à une température de l'ordre de 120°C-350°C.

4. Procédé selon la revendication 3,
**caractérisé en ce que**
le dépôt et le développement de la couche (3) se font dans une atmosphère de gaz inerte.

5. Procédé selon l'une des revendications précédentes,
**caractérisé en ce qu'**
on dépose et on développe une couche (3) en argent à une pression de l'ordre de 100-1000 Pa dans une atmosphère He.
